# EUROPEAN PATENT SPECIFICATION

(11) **EP 2 943 820 B1**
(45) Date of publication and mention of the grant of the patent: **17.02.2021**
(21) Application number: 14700418.8
(22) Date of filing: 14.01.2014
(51) Int. Cl.: G02B 3/00, B29D 11/00, G02B 13/00, H01L 27/146, G02B 27/00

(54) **A LENS ARRAY AND A METHOD OF MAKING A LENS ARRAY**
LINSENANORDNUNG UND VERFAHREN ZUR HERSTELLUNG EINER LINSENANORDNUNG
RÉSEAU DE LENTILLES ET PROCÉDÉ DE RÉALISATION DE RÉSEAU DE LENTILLES

(30) Priority: 14.01.2013 GB 201300635
(43) Date of publication of application: 18.11.2015
(73) Proprietor: Kaleido Technology ApS, 3520 Farum (DK)
(72) Inventor: IBSEN, Per, DK-3520 Farum (DK); SORTKJAER, Kasper, DK-3520 Farum (DK)
(74) Representative: Beck Greener LLP
(86) International application number: PCT/EP2014/050622
(87) International publication number: WO 2014/108566

(56) References cited:
- WO-A2-2011/063347
- US-A1- 2003 081 312
- US-A1- 2005 002 105
- US-A1- 2009 141 361
- US-A1- 2010 033 647
- US-A1- 2010 052 192
- US-A1- 2010 117 176

## Description

The present invention relates to a lens array and a method of making a lens array. "Lens array" is used herein to refer to an array of individual lenses or an array of lens stacks.

In various devices, plural lenses are used in an array configuration arranged to receive light along plural optical paths, instead of using a single lens or lens stack with a single optical path. Some modern mobile telephones or digital cameras include an array of lenses or lens stacks. Such an array can be used to improve the image quality derivable from the camera or device in question. Each individual lens or lens stack provides a unique viewpoint having its own defined optical path. In some cases the device can function to combine all the data received from the multiple viewpoints so as to build a single high-quality image. Alternatively, individual images from the individual lenses or lens stacks within the array can be used so as to generate a three-dimensional image from the camera. In all cases, it is important that the relative positioning of the individual lenses or stacks is known. In other words, the position of one lens within the array with respect to the other lenses in the array is important, particularly if a three-dimensional image is to be produced from the captured image data. In another example, instead of producing three-dimensional images from such a lens array, each of the individual lenses within the array may be provided with a different colour filter such as to provide individual colour filtered images for further processing. In all cases, the relative positioning of the individual lenses or lens stacks within the array is important.

US2009141361 describes an imaging device including a plurality of pixels having a photoelectric conversion function, and a microlens array including a plurality of microlenses that form subject images on these plurality of pixels and are arranged in a matrix are disposed so as to face each other. US2010033647 describes a display element and electronic element module in which a lens is formed as part of a translucent support substrate having a display disposed thereon, the lens being formed on a part other than where the display is disposed, where an electronic element is disposed for the lens. WO2011063347 describes lens stack arrays that include lens elements formed on substrates separated by spacers, where the lens elements, substrates and spacers are configured to form a plurality of optical channels, at least one aperture located within each optical channel, at least one spectral filter located within each optical channel, where each spectral filter is configured to pass a specific spectral band of light, and light blocking materials located within the lens stack array to optically isolate the optical channels. US2010052192 describes an electronic element wafer module in which a transparent support substrate is disposed facing a plurality of electronic elements formed on a wafer and a plurality of wafer-shaped optical elements are disposed on the transparent support substrate, where a groove is formed along a dicing line between the adjacent electronic elements, penetrating from the optical elements through the transparent support substrate, with a depth reaching a surface of the wafer or with a depth short of the surface of the wafer; and a light shielding material is applied on side surfaces and a bottom surface of the groove or is filled in the groove, and the light shielding material is applied or formed on a peripheral portion of a surface of the optical element, except for on a light opening in a center of the surface.

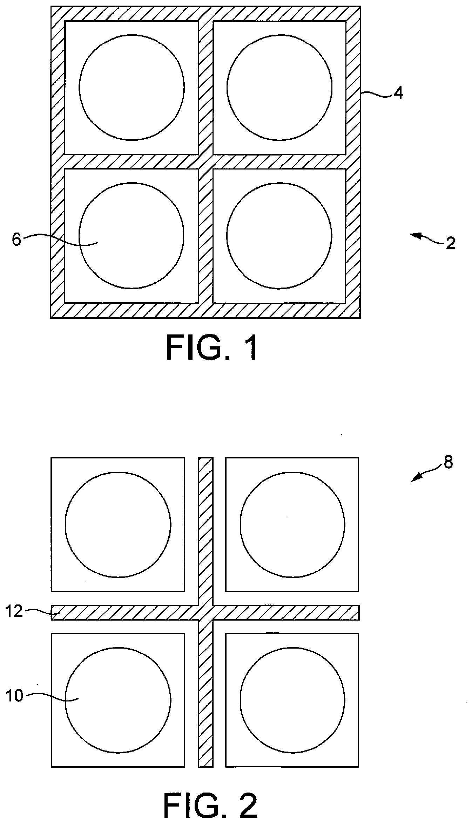

Conventionally, the means by which the relative positioning of the individual lenses within a lens array is achieved is with the use of a lens alignment frame. Figure 1 shows a schematic representation of a lens array comprising plural lenses. Each lens is a single unitary lens although it will be appreciated that in place of each single lens, a lens stack can be used, i.e. there could be four lens stacks instead of four individual lenses. For conciseness throughout the term "lens" will be taken to encompass "lens stack" too.

The array 2 comprises a frame 4 having arranged within it four individual lenses 6. Each of the lenses 6 may be formed on a square prism of optical material which fits into a corresponding opening within the frame 4. The frame 4 is configured such that the relative positioning of the individual lenses 6, with respect to each other, is known when the lenses are arranged within the frame. Although a lens array such as that shown in Figure 1 works well, the assembly of the array can be difficult. In particular, each of the lenses 6 is formed individually and must then be assembled within the corresponding opening within the frame 4. Such a process is time consuming and prone to error. Furthermore, any slight misalignment of the individual lenses can cause errors in the images subsequently captured and processed.

According to a first aspect of the present invention, there is provided a method of forming a crosstalk-supressed lens array, as defined in claim 1.

A method of forming a lens array is provided that ensures accurate relative alignment and positioning of the individual lenses or lens stacks. In particular use of a unitary lens array preform determines at the outset the relative position of the lens elements. A trench is then formed in the unitary preform which is filled with a light absorbent material or mixture so as to limit or avoid crosstalk between individual lenses without in anyway affecting the alignment and relative positioning of the individual lenses. Previously, if a frame was used in to which individual lenses were placed there was a greater chance of misalignment and mis-positioning of individual lens elements. Furthermore the process of assembly was time consuming and prone to error.

As mentioned above, the first aspect of the invention refers to individual lenses. Each lens within the array may be a stack of lenses having a common or shared optical axis, and thus occupying one position within the lens array.

Preferably, the method comprises forming the trenches using a method selected from the group including milling, laser ablation, etching and cutting. Any appropriate means to form the trench between lenses can be used. However, it is convenient and effective to use one or more of milling, laser ablation, etching, grinding and cutting. Preferably, more than two trenches are formed between two adjacent lenses. Preferably, the plural trenches are offset laterally but overlap vertically so as to entirely shield the respective lenses from crosstalk from the adjacent lens.

By providing vertically overlapping laterally offset trenches as defined in product claim 9 is possible to ensure that the lens array retains its unitary structure throughout even though all the trenches can be formed at the same time or in the same process step. In a particularly preferred example, the trenches are formed simultaneously so that all trench formation can be performed at the same time and thus the production time or cycle can be kept to a minimum.

Preferably, the plural trenches are aligned laterally. Preferably, the second trench extends into the first trench. Thus a complete barrier can be formed between adjacent lenses in the array. Preferably, providing the light absorbent material comprises providing a material having substantially the same refractive index as the lenses themselves. This has the advantage that at the boundary with the lens, the incident light "sees" no boundary and therefore will not be reflected. Preferably, providing the light absorbent material comprises providing a matrix optical material having substantially the same refractive index as the lenses themselves together with light absorbent particles suspended therein. The concentration and size of the light absorbing particles is selected to ensure sufficient absorption of received light.

There is also disclosed herein an example in which the array is a two by two array of lenses and a method that comprises forming a first barrier between a first pair of the lenses and a second barrier transverse to the first so as to optically isolate each of the individual lenses. The specific non-limiting example of a two-by-two array is given although it will be appreciated that other two dimensional arrays could also be used. It would be preferred that whatever size of array is used, barriers are formed so as to optically isolate each of the array elements.

According to a second aspect of the present invention, there is provided a crosstalk-supressed lens array, as defined in claim 9.

Preferably, the array is formed as a unitary optical component. Preferably, the barrier comprises a light absorbent material having substantially the same refractive index as the lenses in the array. Preferably, the light absorbent material is a paint or glue arranged between the two adjacent lenses to hold the array together and block light transmission between the two adjacent lenses.

Embodiments of the present invention will now be described in detail with reference to the accompanying drawings, in which:
Figure 1 is a schematic representation of a lens array;
Figure 2 is a schematic representation of a lens array;
Figure 3 shows a schematic representation of a side view of a lens arrays preform;
Figures 4A to 4E show the stages in the formation of a lens array starting with the preform of Figure 3;
Figure 5 shows a plan view of formed lens array;
Figure 6 shows an embodiment of a crosstalk-suppressed lens array according to the invention. Figure 7 shows an example lens array not falling under the scope of the claims.
Figure 8 is a schematic representation of a lens stack.

Figure 2 is a schematic representation of a plan view of an example of an optical lens array. The lens array is a unitary structure 8 comprising four individual lens elements 10 with a dividing boundary 12. The boundary 12 is formed of a light absorbent structure which serves to block stray light from one lens interfering with light in another. In other words it provides a means by which optical crosstalk between the individual lenses in the array can be minimised or avoided. The lens array is shown as a two-by-two array but it will be appreciated that it could be any of any desired or required size. Other typical examples include one-by-two, three-by-two or three-by-three.

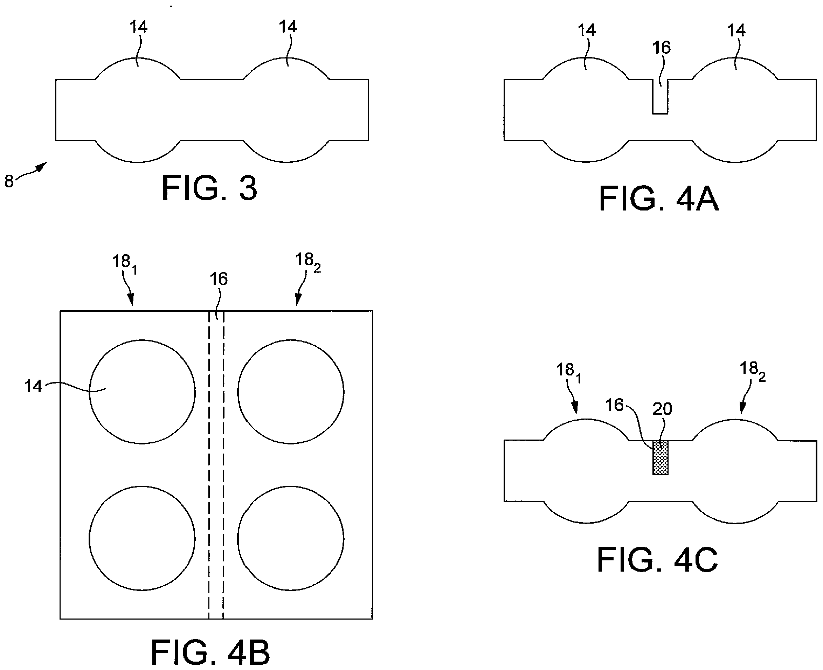

To form a lens array such as that shown in Figure 2, a lens array preform is processed, the preform initially comprises four lens elements formed on a glass substrate. Figure 3 shows a schematic representation of a side view of such a two-by-two lens array preform 9. As used herein the term preform is used to designate an optical structure which is at an intermediate stage of production. Thus, in this example, the lens array preform 9 has plural lenses 14 but needs further processing as will now be explained.

The preform 9 is formed as a unitary body of an optical material such as glass or optical polymer. By forming the array as a unitary body, the relative positioning between the individual lenses 14 within the array or preform can be accurately determined. For example, a single mask or mold may be used to form plural lens elements on a single glass wafer. Blocks of four or more preforms can then be "cut out" from the wafer so as to produce the lens array preform as shown in Figure 3. Previously, even if wafer scale molding was used, once the wafer with plural lens elements was formed, individual lens elements would be cut out from the wafer for assembly within a frame as explained above.

Although by itself, the preform of Figure 3 could work well so long as all received light was channelled within an individual one of the lenses, in practice, this would not always happen due to the variation in the angle of incidence on light received by the array.

Some means for absorbing interference between the lenses, i.e. optical crosstalk, is provided and the means by which this is formed within the lens array 8 will now be described with reference to Figures 4A to 4D.

Initially, referring to Figure 4A, a trench 16 is formed that extends between the lens elements 14. Figure 4B shows a plan view of the arrangement of Figure 4A. As can be seen, the array comprises four lens elements and the trench 16 extends longitudinally across the whole device such as to subdivide the lens elements into two separate groups 18₁ and 18₂. The trench extends some proportion, say between 50 and 90%, of the thickness (or depth) through the array, but not all the way through. This way the unitary nature of the preform is maintained. In other words, even with the trench formed in the preform, the resultant structure is a unitary single component in which the relative position of the lens elements is at it was prior to production of the trench.

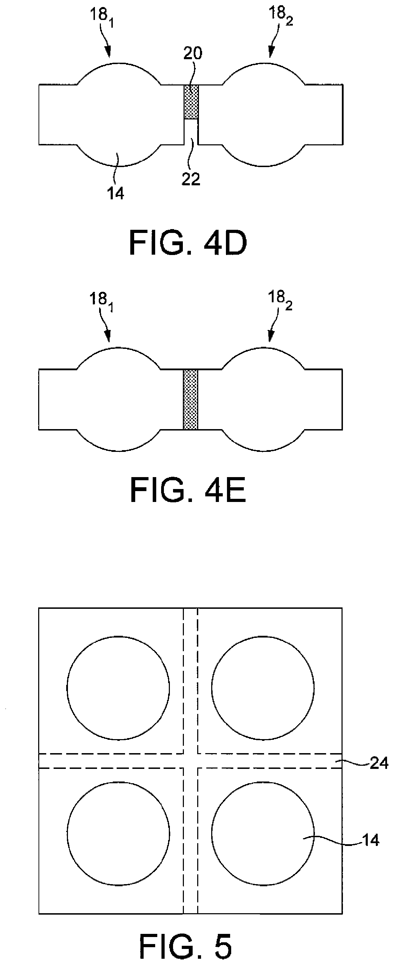

Next, as seen in Figure 4C, the trench 16 is filled with a light absorbent material 20. The material used to fill the trench 16 may be a curable polymer material which serves to absorb light that crosses into it. Initially, the polymer may be in liquid form and may be provided within the trench. Then, the array is irradiated with curing radiation, typically Ultra Violet, so as to solidify the vertical optical barrier. Thus, a partial vertical barrier has been formed between the groups 18₁ and 18₂ of lens elements. Although, depending on the depth of the trench 16, this may be sufficient to limit crosstalk to an acceptable level between the lenses in the array, in a preferred example, the barrier is completed as now described with reference to Figure 4D.

A second trench 22 is formed, aligned with the first trench 16, but on the opposite surface of the array 8, such as to join the now solidified or cured barrier 20. In an example the depth of the second trench 22 is sufficient to extend some way into the formed barrier 20. Next, a light absorbent material is provided in the second trench 22 such as to complete the vertical barrier between the lens groups 18₁ and 18₂. This is shown clearly in Figure 4E. Again, as with the first trench 16, once the second trench 22 is formed, a curable polymer material which serves to absorb light that crosses into it is provided in the second trench 22, which is then cured. There is now a completed vertical barrier between the two groups 18₁ and 18₂ of lens elements, which extends through the whole depth of the lens array.

Next, the process is repeated such as to provide a barrier between the individual lenses within each of the groups 18₁ and 18₂, i.e. transverse to the formed barrier. Figure 5 shows a plan view of the resulting structure from above. As can be seen, there is a cross-like arrangement of light absorbent barriers 24 which ensures that each one of the individual lens elements 14 is effectively optically isolated. This has been achieved without at any stage separating the individual lens elements from each other or the lens array which has retained a unitary structure throughout. Therefore, the relative alignment and positioning of the individual lens elements 14 is as it was when originally formed without any of the light absorbent barriers. Thus, the device remains a unitary structure which therefore improves the reliability of the relative lens element alignment and the subsequent optical performance.

Of course, in some cases once the trench has been formed and filled, the body of material on either side of the trench may move dependent on whether the volume of material filled into the trench exactly equals the volume of the trench. Indeed, in some cases, it may when first put in to the trench, fill the trench exactly, but then upon curing contract or expand so that the cured volume is different from the original trench volume. The expansion or contraction will be of a known amount and so in any event the precise relative positioning of the optical elements on either side of the trench will be known.

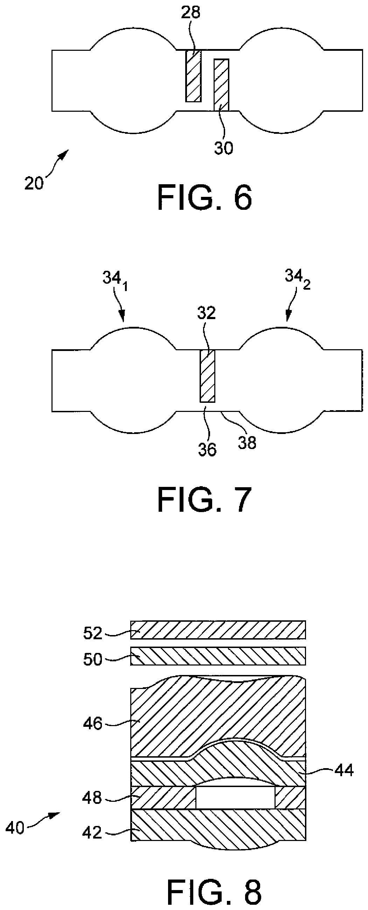

Figure 6 shows a schematic representation of a side view of a lens array. The lens array 26 is of the same general form as that shown in Figure 5. However, in this case, two adjacent trenches 28 and 30 are provided within the lens array, each filled with a light absorbent material. The trenches 28 and 30 are formed as recessed into opposite surfaces of the lens array and offset laterally. Neither of the trenches extends all the way to the other surface of the lens array but, in combination, they provide a complete barrier to light from one side of the lens array to the other. The barriers overlap vertically such that there is no line of sight path from a lens on one side of the barriers to a lens on the other. Such an arrangement is particularly preferred since it will be appreciated that as neither of the trenches extends all the way to the other surface of the lens array, both can be formed in the lens array at the same time and in the same processing step, whilst the array will still retain its unitary character. This therefore enables the formation of the lens array in a quick and efficient manner.

In one example, a lens array preform, such as that shown in Figure 3, is processed so as to form the two trenches 28 and 30. A curable material is provided within each of the trenches and the resultant structure is irradiated with a curing radiation. Thus, in a reduced number of processing steps, the lens array is formed. Again, since the relative positioning of the lenses within the array is not changed during processing, accurate relative alignment and positioning can be achieved.

Figure 7 shows a further example of a lens array. In this example, a single trench 32 is provided between the two sets of lens elements 34₁ and 34₂. The trench 32, filled with an optically absorbent material, does not extend all the way through the lens array. There is a small amount of optical material 36 that is arranged between the bottom of the trench 32 and the surface 38 of the lens array. Such an arrangement is extremely simple to produce since only a single trench is required in the lens array preform. Furthermore, the performance of such a lens array is sufficiently good to make a device such as this effective and useful in its various applications. Although there may be some small amount of stray light from one of the groups of lenses 34₁ to the other 34₂, the amount of crosstalk will be low.

In the embodiment of Figure 6 and the example of Figure 7, it will be noted that the lens arrays comprise plural lenses that are part of the unitary structure of the array. Following a continuous line it is possible to move from any location within the 3D space occupied by the lenses to any other without encountering obstruction. The line will of course have to bend and deviate so as to avoid the light absorbing barriers (i.e. there is not a clear line of sight path between every pair of points in the lenses), but nonetheless it is possible to move from one point in the lenses to any other without leaving the outer boundary of the unitary structure.

Figure 8 shows an example of a lens stack that could take the place of a single lens as the optical component of the arrays of any of Figure 2 to 7. The lens stack 40 comprises three lens elements 42, 44,and 46. A spacer layer 48 is provided and an optical filter 50 together with a protective outer layer 52 is also provided to the lens stack 40. The precise function of each of the lenses 44, 44 and 46 is not particularly important to the present discussion. The array preform in the case of lens stacks being used could be formed by arranging lens wafers having plural lenses in alignment and then fixing and cutting so as to create unitary blocks of plural lens stacks. One or more trenches are then formed in the unitary block of plural lens stacks so as to enable isolation of individual lens stacks in a manner analogous to that described above with respect to Figures 3 to 7.

As mentioned above, the material used to fill the trenches within the lens arrays, is preferably a paint or glue. The paint or glue, when dried or cured, serves to hold the lenses together and absorbs stray optical signals. It is preferred that the material used to fill the light absorbing trenches, has a refractive index substantially the same as that of the bulk material from which the lens elements themselves are formed. This will ensure that light passing from one of the lens elements into the light absorbent barrier will not "see" a boundary and therefore there will be no total internal reflection. Thus, the barrier serves to allow light to travel into it but, once received in the barrier it is absorbed and therefore dissipates within the barrier before leaving to enter an adjacent lens.

In one example, an optically transparent matrix material with the same refractive index as the material of the lens is used in the barrier, with light absorbing particles, e.g. soot, carbon, pigment and the like, suspended therein. The concentration and size of the light absorbing particles is selected to ensure sufficient absorption of received light. This has the advantage that at the boundary with the lens, the incident light "sees" no boundary and therefore will not be reflected.

Embodiments of the present invention have been described with particular reference to the examples illustrated. However, it will be appreciated that variations and modifications may be made to the examples described within the scope of the present invention as defined in the appended claims.

## Claims

1. A method of forming a crosstalk-supressed lens array (8), the method comprising:
providing a unitary lens array preform (9) having plural individual lenses (10, 14) or lens stacks;
forming a first trench (16) between two adjacent individual lenses or lens stacks from a first side of the array;
providing in the first trench a light absorbent material (20) for absorbing optical crosstalk between the two adjacent individual lenses or lens stacks;
forming a second trench (22) between the two adjacent individual lenses or lens stacks from the opposite side of the lens array; and
filling the second trench with light absorbent material and curing it, such that a light absorbent barrier extends all the way through the lens array.

2. A method according to claim 1, in which the method comprises forming the trenches using a method selected from the group including milling, laser ablation, etching, grinding and cutting.

3. A method according to claim 1, in which more than two trenches are formed between two adjacent lenses or lens stacks.

4. A method according to claim 3, in which the trenches (28, 30) are offset laterally but overlap vertically so as to entirely shield the respective lenses or lens stacks from crosstalk from the adjacent lens or lens stack.

5. A method according to claim 3, in which the trenches are aligned laterally.

6. A method according to claim 5, in which the second trench extends into the first trench.

7. A method according to any of claims 1 to 6, in which providing the light absorbent material comprises providing a material having substantially the same refractive index as the lenses or optical material of the lens stacks themselves.

8. A method according to claim 7, in which providing the light absorbent material comprises providing a matrix optical material having substantially the same refractive index as the lenses or optical material of the lens stacks themselves together with light absorbent particles suspended therein.

9. A crosstalk-supressed lens array (8), comprising:
plural optical lenses (10, 14) or lens stacks arranged in an array;
an optical barrier arranged between one of the plural optical lenses or lens stacks and an adjacent one of the plural optical lenses or lens stacks to absorb crosstalk between the two adjacent lenses or lens stacks, wherein the array is made using the method of any of claims 1 to 8;
wherein the optical barrier extends throughout the full depth of the lens array; and
wherein the barrier comprises two or more vertically arranged laterally offset trenches (28, 30), each filled with a cured light absorbent material, overlapping so as in combination to provide a barrier across the entire boundary of two adjacent lenses or lens stacks.

10. A lens array according to claim 9, in which the barrier comprises a light absorbent material having substantially the same refractive index as the lenses or lens stacks in the array.

11. A lens array according to claim 9 or 10, in which the light absorbent material is a paint or glue arranged between the two adjacent lenses or lens stacks to hold the array together and block light transmission between the two adjacent lenses or lens stacks.

## Patentansprüche

1. Verfahren zum Ausbilden eines nebensprechgesperrten Linsenarrays (8), wobei das Verfahren Folgendes umfasst:
Bereitstellen einer einheitlichen Linsenarrayvorform (9), die mehrere Einzellinsen (10, 14) oder Linsenstapel aufweist;
Ausbilden einer ersten Vertiefung (16) zwischen zwei benachbarten Einzellinsen oder Linsenstapeln von einer ersten Seite des Arrays;
Bereitstellen eines lichtabsorbierenden Materials (20) in der ersten Vertiefung zum Absorbieren von optischem Nebensprechen zwischen den zwei benachbarten Einzellinsen oder Linsenstapeln;
Ausbilden einer zweiten Vertiefung (22) zwischen den beiden benachbarten Einzellinsen oder Linsenstapeln von der gegenüberliegenden Seite des Linsenarrays; und
Füllen der zweiten Vertiefung mit lichtabsorbierendem Material und Aushärten derselben derart, dass sich eine lichtabsorbierende Barriere durch das gesamte Linsenarray hindurch erstreckt.

2. Verfahren nach Anspruch 1, wobei das Verfahren das Ausbilden der Vertiefungen unter Verwendung eines Verfahrens umfasst, das aus der Gruppe ausgewählt ist, die Fräsen, Laserablation, Ätzen, Schleifen und Schneiden beinhaltet.

3. Verfahren nach Anspruch 1, wobei mehr als zwei Vertiefungen zwischen zwei benachbarten Linsen oder Linsenstapeln ausgebildet werden.

4. Verfahren nach Anspruch 3, wobei die Vertiefungen (28, 30) seitlich versetzt sind, sich aber vertikal überlappen, um die jeweiligen Linsen oder Linsenstapel gegen Nebensprechen von der benachbarten Linse oder dem benachbarten Linsenstapel vollständig abzuschirmen.

5. Verfahren nach Anspruch 3, wobei die Vertiefungen seitlich ausgerichtet sind.

6. Verfahren nach Anspruch 5, wobei sich die zweite Vertiefung in die erste Vertiefung erstreckt.

7. Verfahren nach einem der Ansprüche 1 bis 6, wobei das Bereitstellen des lichtabsorbierenden Materials das Bereitstellen eines Materials umfasst, das im Wesentlichen den selben Brechungsindex wie die Linsen oder das optische Material der Linsenstapel selbst aufweist.

8. Verfahren nach Anspruch 7, wobei das Bereitstellen des lichtabsorbierenden Materials das Bereitstellen eines optischen Matrixmaterials umfasst, das im Wesentlichen den selben Brechungsindex wie die Linsen oder das optische Material der Linsenstapel selbst aufweist, zusammen mit lichtabsorbierenden Partikeln, die darin suspendiert sind.

9. Nebensprechgesperrtes Linsenarray (8), das Folgendes umfasst:
mehrere optische Linsen (10, 14) oder Linsenstapel, die in einem Array angeordnet sind;
eine optische Barriere, die zwischen einer der mehreren optischen Linsen oder Linsenstapel und einer benachbarten der mehreren optischen Linsen oder Linsenstapel angeordnet ist, um ein Nebensprechen zwischen den beiden benachbarten Linsen oder Linsenstapeln zu absorbieren, wobei das Array unter Verwendung des Verfahrens nach einem der Ansprüche 1 bis 8 hergestellt wird;
wobei sich die optische Barriere über die gesamte Tiefe des Linsenarrays erstreckt; und
wobei die Barriere zwei oder mehr vertikal angeordnete, seitlich versetzte Vertiefungen (28, 30) umfasst, von denen jede mit einem gehärteten, lichtabsorbierenden Material gefüllt ist, die sich überlappen, um in Kombination eine Barriere über die gesamte Grenze von zwei benachbarten Linsen oder Linsenstapeln bereitzustellen.

10. Linsenarray nach Anspruch 9, wobei die Barriere ein lichtabsorbierendes Material umfasst, das im Wesentlichen den selben Brechungsindex wie die Linsen oder Linsenstapel in dem Array aufweist.

11. Linsenarray nach Anspruch 9 oder 10, wobei das lichtabsorbierende Material eine Farbe oder ein Klebstoff ist, der zwischen den beiden benachbarten Linsen oder Linsenstapeln angeordnet ist, um das Array zusammenzuhalten und eine Lichtübertragung zwischen den beiden benachbarten Linsen oder Linsenstapeln zu blockieren.

## Revendications

1. Procédé de formation d'un réseau de lentilles avec suppression de la diaphonie (8), le procédé comprenant :
la fourniture d'une préforme de réseau de lentilles unitaire (9) ayant de multiples lentilles individuelles (10, 14) ou piles de lentilles ;
la formation d'une première tranchée (16) entre deux lentilles individuelles ou piles de lentilles adjacentes à partir d'un premier côté du réseau ;
la fourniture dans la première tranchée d'un matériau absorbant la lumière (20) pour absorber la diaphonie optique entre les deux lentilles individuelles ou piles de lentilles adjacentes ;
la formation d'une seconde tranchée (22) entre les deux lentilles individuelles ou piles de lentilles adjacentes du côté opposé du réseau de lentilles ; et
le remplissage de la seconde tranchée avec un matériau absorbant la lumière et son durcissement, de sorte qu'une barrière absorbant la lumière s'étend e tout au long du réseau de lentilles.

2. Procédé selon la revendication 1, dans lequel le procédé comprend la formation des tranchées en utilisant un procédé choisi dans le groupe comprenant le fraisage, l'ablation au laser, la gravure, le meulage et la découpe.

3. Procédé selon la revendication 1, dans lequel plus de deux tranchées sont formées entre deux lentilles ou piles de lentilles adjacentes.

4. Procédé selon la revendication 3, dans lequel les tranchées (28, 30) sont décalées latéralement, mais se chevauchent verticalement de manière à protéger entièrement les lentilles ou piles de lentilles respectives de ladiaphonie provenant des lentilles ou piles de lentilles adjacentes.

5. Procédé selon la revendication 3, dans lequel les tranchées sont alignées latéralement.

6. Procédé selon la revendication 5, dans lequel la seconde tranchée s'étend dans la première tranchée.

7. Procédé selon l'une quelconque des revendications 1 à 6, dans lequel la fourniture du matériau absorbant la lumière comprend la fourniture d'un matériau ayant sensiblement le même indice de réfraction que les lentilles ou que le matériau optique des piles de lentilles elles-mêmes.

8. Procédé selon la revendication 7, dans lequel la fourniture du matériau absorbant la lumière comprend la fourniture d'un matériau optique matriciel ayant sensiblement le même indice de réfraction que les lentilles ou que le matériau optique des piles de lentilles elles-mêmes avec des particules absorbant la lumière suspendues à l'intérieur.

9. Réseau de lentilles avec suppression de la diaphonie (8), comprenant :
de multiples lentilles optiques (10, 14) ou piles de lentilles disposées en un réseau ;
une barrière optique disposée entre l'une des multiples lentilles optiques ou piles de lentilles et l'une des multiples lentilles optiques ou piles de lentilles adjacentes po ur absorber la diaphonie entre les deux lentilles ou piles de lentilles adjacentes, dans lequel le réseau est fabriqué en utilisant le procédé de l'une quelconque des revendications 1 à 8;
dans lequel la barrière optique s'étend sur toute la profondeur du réseau de lentilles ; et
dans lequel la barrière comprend au moins deux tranchées décalées latéralement disposées verticalement (28, 30), chacune étant remplie d'un matériau durci absorbant la lumière, se chevauchant de manière à fournir par combinaison u ne barrière sur toute la limite de deux lentilles ou piles de lentilles adjacentes.

10. Réseau de lentilles selon la revendication 9, dans lequel la barrière comprend un matériau absorbant la lumière ayant sensiblement le même indice de réfraction que les lentilles ou les piles de lentilles dans le réseau.

11. Réseau de lentilles selon la revendication 9 ou 10, dans lequel le matériau absorbant la lumière est une peinture ou une colle disposée entre les deux lentilles ou piles de lentilles adjacentes pour maintenir l'unité du réseau et bloquer la transmission de la lumière entre les deux lentilles ou piles de lentilles adjacentes.
